(19) Europäisches Patentamt / European Patent Office / Office européen des brevets

(11) **EP 4 434 806 A1**

(12) **EUROPEAN PATENT APPLICATION**
published in accordance with Art. 153(4) EPC

(43) Date of publication:
**25.09.2024 Bulletin 2024/39**

(21) Application number: **22913646.0**

(22) Date of filing: **12.10.2022**

(51) International Patent Classification (IPC):
**B60L 58/10** $^{(2019.01)}$

(52) Cooperative Patent Classification (CPC):
**B60L 58/10**

(86) International application number:
**PCT/CN2022/124837**

(87) International publication number:
**WO 2023/124382 (06.07.2023 Gazette 2023/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.12.2021 CN 202111657500**

(71) Applicant: **ZTE Corporation**
**Shenzhen, Guangdong 518057 (CN)**

(72) Inventor: **TENG, Yiming**
**Shenzhen, Guangdong 518057 (CN)**

(74) Representative: **Osterhoff, Utz**
**Bockermann Ksoll**
**Griepenstroh Osterhoff**
**Patentanwälte**
**Bergstraße 159**
**44791 Bochum (DE)**

(54) **BATTERY PACK CONTROL METHOD AND SYSTEM, AND COMPUTER-READABLE STORAGE MEDIUM**

(57) The present disclosure relates to the field of battery control, and discloses a method and system for controlling a battery pack, and a computer-readable storage medium. The method for controlling the battery pack is applied to the system for controlling the battery pack. The method includes: dividing the battery pack into multiple battery subsystems; obtaining a step response matrix between each of the battery subsystems; and establishing a battery pack objective function of the system for controlling the battery pack according to the step response matrix; obtaining a battery pack control function according to the battery pack objective function; and controlling the voltage and/or current output of each of the battery subsystems according to the battery pack control function.

FIG. 1

Description

CROSS-REFERENCES TO RELATED APPLICATIONS

This application claims priority to Chinese Patent Application NO. 202111657500.9, entitled "METHOD AND SYSTEM FOR CONTROLLING BATTERY PACK, AND COMPUTER-READABLE STORAGE MEDIUM", and filed on December 30, 2021, the entire contents of which are incorporated herein by reference.

TECHNICAL FIELD

The present disclosure relates to the technical field of battery control, and in particular to a method and system for controlling a battery pack, and computer-readable storage medium.

BACKGROUND

With the development of vehicle electrification and intelligence, new energy vehicles are becoming increasingly popular. At present, electric vehicles are the main development direction of new energy vehicles, the core of electric vehicles is the battery pack, and the core of the battery pack is a battery pack management system. Having a better battery pack control algorithm can improve the driving range and battery pack safety of electric vehicles, protecting vehicle life and driving safety.

SUMMARY

The purpose of the embodiments of the present disclosure is to provide a method and a system for controlling a battery pack, and a computer-readable storage medium.

According to an aspect of the present disclosure, an embodiment of the present disclosure provides a method for controlling a battery pack, applied to a system for controlling the battery pack. The method includes: dividing the battery pack into multiple battery subsystems; obtaining a step response matrix between each of the battery subsystems; establishing a battery pack objective function of the system for controlling the battery pack according to the step response matrix; obtaining a battery pack control function according to the battery pack objective function; and controlling a voltage and/or current output of each of the battery subsystems according to the battery pack control function.

According to an aspect of the present disclosure, an embodiment of the present disclosure provides a system for controlling a battery pack. The system includes at least one processor and a memory communicated with the at least one processor. An instruction executable by the at least one processor is stored in the memory, and the instruction is executed by the at least one processor to enable the at least one processor to perform the method for controlling the battery pack as described above.

According to an aspect of the present disclosure, an embodiment of the present disclosure provides a computer-readable storage medium, a computer program is stored on the computer-readable storage medium, and when the computer program is executed by a processor, the method for controlling the battery pack as described above is implemented.

BRIEF DESCRIPTION OF THE DRAWINGS

FIG. 1 is a schematic flowchart of a method for controlling a battery pack according to a first embodiment of the present disclosure.

FIG. 2 is a schematic flowchart of a method for controlling a battery pack according to a second embodiment of the present disclosure.

FIG. 3 is a schematic structural diagram of a method for controlling a battery pack according to a third embodiment of the present disclosure.

DETAILED DESCRIPTION OF THE EMBODIMENTS

In order to make the purpose, technical solutions and advantages of the present disclosure clearer, embodiments of the present disclosure will be described in detail below with reference to the accompanying drawings. However, those skilled in the art will understand that in each embodiment of the present disclosure, many technical details are provided to enable the reader to better understand the present disclosure. However, even without these technical details and various changes and modifications based on the following embodiments, the technical solution in the present disclosure can also be implemented.

In the field of controlling a battery pack, the related art lacks excellent control algorithms and the control level of the battery pack is low, resulting in low reliability of a battery pack system.

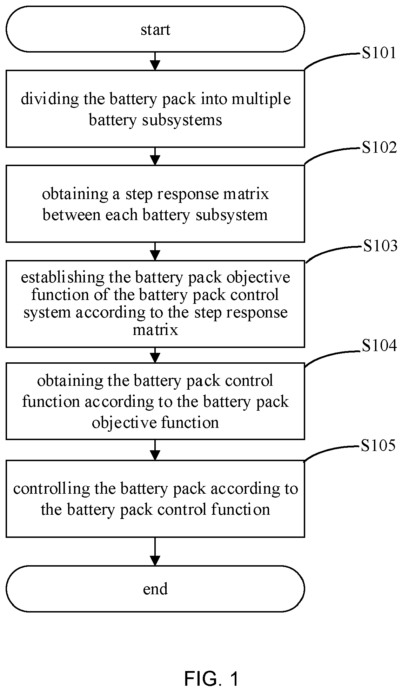

A first embodiment of the present disclosure relates to a method for controlling a battery pack, applied to a system for controlling the battery pack. The flowchart of this method is shown in FIG. 1, including the following steps S101 to S105.

Step S101, dividing the battery pack into multiple battery subsystems.

The battery pack includes multiple batteries. The battery models of each battery can be the same or different. The charge and discharge characteristics of each battery can characterize the characteristics of the battery. Therefore, the battery model corresponding to each battery can be obtained through the charge and discharge characteristics of each battery.

After obtaining the battery model corresponding to each battery, the battery subsystem corresponding to each battery can be constructed according to the battery model corresponding to each battery, and each battery subsystem can control each battery separately. That is, in this embodiment, a battery management system is dispersed into N battery subsystems, and each battery subsystem controls the corresponding battery.

Step S102, obtaining a step response matrix between each battery subsystem.

In this step, there is mutual communication data transfer between each battery subsystem, so the transfer function between each battery subsystem can be extracted, such as the transfer function from the input of the j-th battery subsystem to the output of the i-th battery subsystem is:

$$G_{ij}(s) = \frac{K_{ij} e^{-\tau_{ij} s}}{T_{ij} s + 1} \quad \ldots \quad （\text{Equation 1}）$$

According to Equation 1, i and j are from 1 to N, thereby obtaining the transfer function of each battery subsystem. That is, each battery subsystem is configured as a target battery subsystem in turn, and then the transfer function from the input of each other battery subsystem to the output of the current target battery subsystem is obtained in turn, that is, each battery subsystem can obtain N-1 transfer functions.

The obtained transfer functions are converted into a discrete difference model, and the following results are obtained:

$$y(k) = \varphi(k)^T \theta(k) \quad \ldots\ldots \quad （\text{Equation 2}）\quad ;$$

where

$$\varphi(k)^T = \left[-y(k-1), -y(k-2), \mathrm{L}, -y(k-na), u(k-1), \mathrm{L}, u(k-nb)\right],$$

$$\theta(k) = \left[a_1, a_2, \cdots, a_{na}, b_1, \cdots, b_{nb}\right]^T ;$$

y is an output value at different times after the transfer function is converted into the discrete difference model. For example, y(k-1) represents the output value at time (k-1); u is an output value at different times after the transfer function is converted into the discrete difference model. For example, u(k-1) represents the input value at time (k-1), k, na and nb all represent time. For example, k-na represents at time (k-na), each element in $\theta(k)$ corresponds to the coefficient in front of each element in $\varphi(k)^T$.

For the above Equation 2, the recursive least squares algorithm is used to obtain the model parameters of the discrete difference model, as shown in Equation 3:

$$\hat{\theta}(k) = \hat{\theta}(k-1) + K(k)\left[y(k) - \varphi(k-1)^T \hat{\theta}(k-1)\right] \quad \ldots\ldots \text{（Equation 3）}\ ;$$

where

$$K(k) = \frac{P(k-1)\varphi(k-1)}{1 + \varphi(k-1)^T P(k-1)\varphi(k-1)}, \quad P(k) = \left[I - K(k)\varphi(k-1)^T\right]P(k-1)$$

For Equation 3, the discrete difference model is converted into a non-parametric impulse response model, such as shown in Equation 4:

$$\hat{g}(z^{-1}) = \frac{\hat{B}(z^{-1})}{\hat{A}(z^{-1})} \quad \ldots\ldots \text{（Equation 4）}\ ;$$

where,

$$\hat{g}_1 + \hat{g}_2 z^{-1} + \cdots + \hat{g}_N z^{-N+1} = \frac{\hat{b}_1 + \hat{b}_2 z^{-1} + \cdots + \hat{b}_{nb} z^{-nb+1}}{1 + \hat{a}_1 z^{-1} + \cdots + \hat{a}_{na} z^{-na}}.$$

Next, the impulse response coefficient is obtained according to the non-parametric impulse response model, for example, as shown in Equation 5. The sorted impulse response coefficient is:

$$\begin{cases} \hat{g}_1 = \hat{b}_1 \\ \hat{g}_2 = \hat{b}_2 - \hat{a}_1 \hat{g}_1 \\ \hat{g}_3 = \hat{b}_3 - \hat{a}_1 \hat{g}_2 - \hat{a}_2 \hat{g}_1 \\ \quad\vdots \\ \hat{g}_1 = \hat{b}_{k+1} - \sum_{i=1}^{k} \hat{a}_i \hat{g}_{n-i+1} \end{cases} \quad \ldots\ldots \text{（Equation 5）}\ ;$$

In Equation 5, when $k \geq nb$, $\hat{b}_k = 0$; and when $i \geq na$, $\hat{a}_i = 0$.

Then, the step response matrix is obtained according to the impulse response data, for example, as shown in Equation 6:

$$\hat{h}_i = \sum_{j=1}^{i} \hat{g}_i \left(i = 1, 2, \cdots, N\right) \quad \ldots\ldots \text{（Equation 6）}\ ;$$

then,

$$h = \begin{bmatrix} h_1 & h_1 & \cdots & h_N \end{bmatrix}^T .$$

The established step response matrix is shown in Equation 7:

$$A = \begin{bmatrix} h_1 & 0 & \cdots & 0 \\ h_2 & h_1 & \cdots & 0 \\ \vdots & \vdots & \vdots & \vdots \\ h_P & h_{P-1} & \cdots & h_{P-M+1} \end{bmatrix} \quad \cdots\cdots \text{ (Equation 7) .}$$

Step S103, establishing the battery pack objective function of the battery pack control system according to the step response matrix.

In this step, the battery objective function of each battery is established according to the step response matrix first, for example, as shown in Equation 8:

$$\min J(k) = \left\| w(k) - y_{PM}(k) \right\|_Q^2 + \left\| \Delta u_M(k) \right\|_R^2$$
$$= \Delta u_M(k)^T \left( A^T Q A + R \right) \Delta u_M(k) - 2 A^T Q \left[ w(k) - y_{P0}(k) \right] \Delta u_M(k) + \left[ w(k) - y_{P0}(k) \right]^T Q \left[ w(k) - y_{P0}(k) \right]$$

$$\cdots\cdots \text{ (Equation 8) ;}$$

where $[w(k)-y_{P0}(k)]^T Q[w(k)-y_{P0}(k)]$ is known, $y_{PM}(k)$ is the predicted current output value of each battery at time k, $y_{P0}(k)$ is the initial predicted current value of each battery at time k, $w(k)$ is the reference trajectory of the expected current output for the battery pack at time k, $Q$ and $R$ are the error and the control weighting coefficient matrix, $\Delta u_M(k)$ is the control current variable of the battery pack at time k. The known part of Equation 8 is omitted, and Equation 9 can be obtained as:

$$\min J(k) = \frac{1}{2} \Delta u_M(k)^T H \Delta u_M(k) + f^T \Delta u_M(k) \quad \cdots\cdots \text{ (Equation 9) ;}$$

where

$$H = 2\left( A^T Q A + R \right), \quad f = -2\left[ A^T Q \left( w(k) - y_{P0}(k) \right) \right]^T$$

By extending the battery objective function of each battery to the entire battery pack control system, the battery pack function of the battery pack can be established as the objective function. For example, Equation 10 is as follows:

$$\min J_i(k) = \left\| w_i(k) - y_{i,PM}(k) \right\|_{Q_i}^2 + \left\| \Delta u_{i,M}(k) \right\|_{R_i}^2$$
$$= \Delta u_{i,M}(k)^T \left( A_{ii}^T Q_i A_{ii} + R_i \right) \Delta u_{i,M}(k) - 2 A_{ii}^T Q_i \left[ w_i(k) - y_{i,p0}(k) - \sum_{j=1,j \neq i}^{M} A_{ij} \Delta u_{j,M}(k) \right] \Delta u_{i,M}(k)$$
$$+ \left[ w_i(k) - y_{i,p0}(k) \right]^T Q_i \left[ w_i(k) - y_{i,p0}(k) \right] - 2 \left[ w_i(k) - y_{i,p0}(k) \right]^T Q_i \sum_{j=1,j \neq i}^{M} A_{ij} \Delta u_{j,M}(k)$$
$$+ \left[ \sum_{j=1,j \neq i}^{M} A_{ij} \Delta u_{j,M}(k) \right]^T Q_i \left[ \sum_{j=1,j \neq i}^{M} A_{ij} \Delta u_{j,M}(k) \right] \quad \cdots\cdots \text{ (}$$

Equation 10) ;

where

$$\left[w_i(k)-y_{i,p0}(k)\right]^T Q_i\left[w_i(k)-y_{i,p0}(k)\right], \quad 2\left[w_i(k)-y_{i,p0}(k)\right]^T Q_i\sum_{j=1,j\neq i}^{M}A_{ij}\Delta u_{j,M}(k)$$

and

$$\left[\sum_{j=1,j\neq i}^{M}A_{ij}\Delta u_{j,M}(k)\right]^T Q_i\left[\sum_{j=1,j\neq i}^{M}A_{ij}\Delta u_{j,M}(k)\right]$$

are known.

$y_{i,PM}(k)$ is the predicted current output value of the i-th battery subsystem at time k, $y_{i,P0}(k)$ is the initial predicted current value of the i-th battery subsystem at time k, $w_i(k)$ is the reference trajectory of the given expected current output of the i-th battery subsystem at time k, $w_i(k)$ and $R_i$ are respectively the error and control weighting coefficient matrix of the i-th battery subsystem, and $\Delta u_{i,M}(k)$ is the control current variable of the i-th battery subsystem at time k. The known parts of Equation 10 are omitted, and Equation 10 can be simplified to Equation 11 as:

$$\min J_i(k) = \frac{1}{2}\Delta u_{i,M}(k)^T H\Delta u_{i,M}(k) + f^T \Delta u_{i,M}(k) \qquad \text{....... (Equation 11)} \ ;$$

Where

$$H = 2\left(A_{ii}^T Q_i A_{ii} + R_i\right), \quad f = -2\left[A_{ii}^T Q_i\left(w_i(k) - y_{i,P0}(k) - \sum_{j=1,j\neq i}^{M}A_{ij}\Delta u_{j,M}(k)\right)\right]^T .$$

Step S104, obtaining the battery pack control function according to the battery pack objective function.

In this step, the Nash optimal idea is used to solve the objective function by minimizing the objective function

$$\frac{\partial J_i(k)}{\partial \Delta u_{i,M}(k)} = 0$$

of the battery pack, that is, minimizing and solving Equation 10, which is expressed as: . The Nash optimal solution of the objective function is obtained as the battery pack control function, for example, is shown in Equation 12:

$$\Delta u_{i,M}(k) = \frac{-f}{H^T} = \frac{2\left[A_{ii}^T Q_i\left(w_i(k) - y_{i,p0}(k) - \sum_{j=1,j\neq i}^{M}A_{ij}\Delta u_{j,M}(k)\right)\right]^T}{\left[2A_{ii}^T Q A_{ii} + R_i\right]^T} \qquad \text{....... (Equation 12)} \ .$$

The obtained $\Delta u_{i,M}(k)$ can be configured as the battery pack control function.

Step S105, controlling the battery pack according to the battery pack control function.

In this step, after solving the battery pack control function shown in Equation 12, each battery subsystem can be substituted into Equation 12 for calculation, and the calculation result is configured as the control current of the battery corresponding to each battery subsystem. According to the control current of each battery, the voltage and/or current output of each battery is controlled.

Compared with related art, in the battery pack control method provided by the first embodiment of the present disclosure, the complex and large-scale battery pack control system is dispersed into multiple battery subsystems. When controlling each battery subsystem, the step response matrix between each battery subsystem is obtained through the recursive least squares algorithm. The recursive least squares algorithm is a typical and effective data processing method, which performs an approximation operation on the battery model, so that the identified data used for algorithm operations is closer to the battery model itself. Therefore, it can match the model when the control device is running, so that each battery can achieve better control effects. The battery pack objective function of the battery pack control system is established according to the step response matrix. There is a good connection between the battery pack objective function and each battery. The battery pack objective function can accurately control each battery, thereby controlling the entire battery pack. This effectively improves the stability and reliability of the battery pack control system.

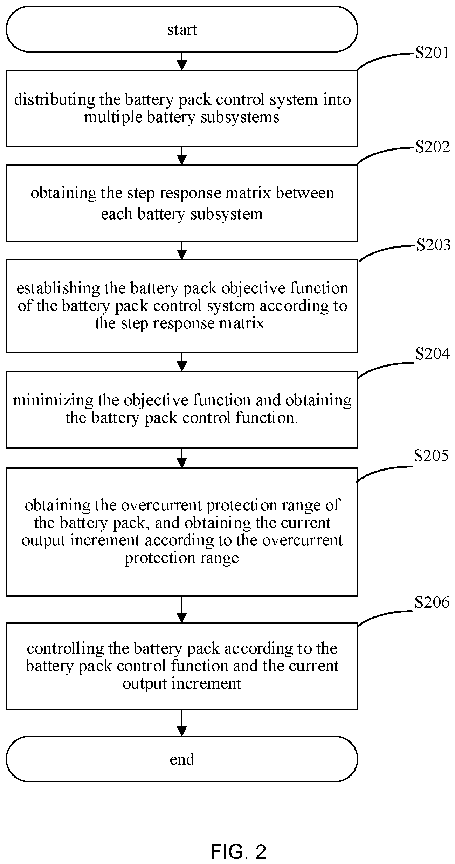

The second embodiment of the present disclosure relates to a method for controlling the battery pack. The steps are shown in FIG. 2 and include steps S201 to S206.

Step S201, distributing the battery pack control system into multiple battery subsystems.

Step S202, obtaining the step response matrix between each battery subsystem.

Step S203, establishing the battery pack objective function of the battery pack control system according to the step response matrix.

Step S204, minimizing the objective function and obtaining the battery pack control function.

It can be understood that steps S201 to S204 in the second embodiment of the present disclosure are substantially the same as steps S101 to S104 in the first embodiment, and reference can be made to the description of the first embodiment, which will not be described again here.

Step S205, obtaining the overcurrent protection range of the battery pack, and obtaining the current output increment according to the overcurrent protection range.

In this step, the constraint matrix is set according to the overcurrent protection range of the battery pack, for example:

$$\Delta u_{\min} \leq \Delta u_{i,M}(k) \leq \Delta u_{\max}, \quad u_{\min} \leq u_{i,M}(k) \leq u_{\max}, \quad y_{\min} \leq y_{i,PM}(k) \leq y_{\max}.$$

make

$$\alpha_q = \begin{bmatrix} \alpha_1^T & -\alpha_1^T & \alpha_2^T & -\alpha_2^T & A_{ii}^T & -A_{ii}^T \end{bmatrix}^T,$$

$$b_q = \begin{bmatrix} b_1^T & b_2^T & b_3^T & b_4^T & b_5^T & b_6^T \end{bmatrix}^T,$$

$$\alpha_1 = \begin{bmatrix} 1 & 0 & \cdots & 0 \\ 0 & 1 & \cdots & 0 \\ \vdots & \vdots & \ddots & \vdots \\ 0 & 0 & \cdots & 1 \end{bmatrix} \quad \alpha_2 = \begin{bmatrix} 1 & 0 & \cdots & 0 \\ 1 & 1 & \cdots & 0 \\ \vdots & \vdots & \ddots & \vdots \\ 1 & 1 & \cdots & 1 \end{bmatrix}$$

Where, when

$$\Delta u_{\min} \leq \Delta u_{i,M}(k) \leq \Delta u_{\max}, \quad b_1 = \Delta u_{\max}, \text{ and } b_2 = -\Delta u_{min};$$

when

$$u_{\min} \leq u_{i,M}(k) \leq u_{\max}, \quad b_3 = u_{\max} - u_i(k-1), \text{ and } b_4 = -u_{\min} + u_i(k-1);$$

when

$$y_{\min} \le y_{i,PM}(k) \le y_{\max}, \qquad y_{\min} \le y_{i,P0}(k) + A_{ii}\Delta u_{i,M}(k) + \sum_{j=1,j\ne i}^{m} A_{ij}\Delta u_{j,M}(k) \le y_{\max}$$

and

$$y_{\min} - y_{i,P0}(k) - \sum_{j=1,j\ne i}^{m} A_{ij}\Delta u_{j,M}(k) \le A_{ii}\Delta u_{i,M}(k) \le y_{\max} - y_{i,P0}(k) - \sum_{j=1,j\ne i}^{m} A_{ij}\Delta u_{j,M}(k),$$

$$b_5 = y_{\max} - y_{i,P0}(k) - \sum_{j=1,j\ne i}^{m} A_{ij}\Delta u_{j,M}(k) \qquad \text{and} \qquad b_5 = y_{\max} - y_{i,P0}(k) - \sum_{j=1,j\ne i}^{m} A_{ij}\Delta u_{j,M}(k).$$

According to the aforementioned constraint matrix, the Nash optimal solution of the objective function is solved here, and a new round of iterative optimal solution at time k can be obtained, as shown in Equation 13:

$$\Delta u_{i,M}^{l+1}(k) = \frac{-f}{H^T} = \frac{2\left[ A_{ii}^{T}Q_i\left( w_i(k) - y_{i,p0}(k) - \sum_{j=1,j\ne i}^{M} A_{ij}\Delta u_{i,M}^{l}(k) \right) \right]^T}{\left[ 2A_{ii}^{T}QA_{ii} + R_i \right]^T} \qquad \cdots\cdots \text{(Equation 13)}$$

;

Thus, the current output increment of the entire battery pack management system at time k is:

$$\Delta u_M^{l+1}(k) = \left[ \Delta u_{1,M}^{l+1}(k), \Delta u_{2,M}^{l+1}(k), \cdots, \Delta u_{N,M}^{l+1}(k) \right]^T.$$

Step S206, controlling the battery pack according to the battery pack control function and the current output increment.

In this step, the first term of the Nash optimal solution (Equation 13) of the i-th battery subsystem at time k is configured as the immediate control current variable $\Delta u_i(k)$, to obtain the actual control current $u_i(k)=u_i(k-1)+\Delta u_i(k)$ of the i-th battery subsystem at time k under the current protection range limit. The battery corresponding to the i-th battery subsystem is controlled according to the actual control current.

At the next moment, repeat the above steps S205 to S206, continue to solve for the instantaneous current increment of the i-th battery subsystem, then obtain the current increment $\Delta u_i(k+1)$ of the entire battery management system at time (k+1), and it cycles to solve each battery subsystem in sequence to complete the control of the entire battery management system.

Compared with the related art, the method for controlling the battery pack provided by the second embodiment of the present disclosure retains the technical effects of the first embodiment, and at the same time, the over-current protection range of the battery pack is newly introduced to recalculated actual control current of each battery. The control current increment within the current protection range is obtained, and the sum of the control current increment and the control current in the first embodiment is configured as the new actual control current, thereby better controlling the battery pack to avoid exceeding the over-current protection range of the battery pack, further increasing the stability of battery pack control.

The steps of the various methods above are divided just for the purpose of clear description. During implementation, they can be combined into one step or some steps can be split into multiple steps. As long as they contain the same logical relationship, they are all within the scope of this patent. Adding insignificant modifications or introducing insignificant designs to the algorithm or process, without changing the core design of the algorithm and process, are within the scope of protection of this patent.

Those skilled in the art can understand that all or some steps of the method, systems, and functional modules/units in the apparatus disclosed above can be implemented as software, firmware, hardware, and appropriate combinations thereof. In hardware implementations, the division between functional modules/units mentioned in the above description does not necessarily correspond to the division of physical components; for example, one physical component may have multiple functions, or one function or step may consist of several physical components. Some or all of the physical components may be implemented as software executed by a processor, such as a central processing unit, a digital signal processor, or a microprocessor, or as hardware, or as an integrated circuit, such as an application specific integrated circuit.

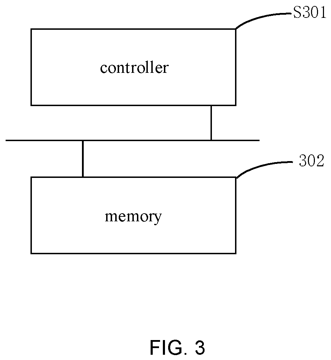

The third embodiment of the present disclosure relates to a system for controlling the battery pack. As shown in FIG. 3, the system may include at least one processor 301 and a memory 302 communicated with the at least one processor 301. An instruction executed by the at least one processor 301 is stored in the memory 302, The instruction is executed by the at least one processor 301 so that the at least one processor 301 can perform the method for controlling the battery pack as provided in the aforementioned first embodiment and second embodiment.

The memory 302 and the processor 301 are connected using a bus. The bus can include any number of interconnected buses and bridges. The bus connects various circuits of one or more processors 301 and the memory 302 together. The bus can also connect various other circuits together such as peripheral devices, voltage regulators, and power management circuits, which are all well known in the art and therefore will not be described further herein. The bus interface provides the interface between the bus and the transceiver. A transceiver can be one element or multiple elements, such as multiple receivers and transmitters, providing a unit for communicating with various other devices over a transmission medium. The data processed by the processor 301 is transmitted on the wireless medium through the antenna. Furthermore, the antenna also receives the data and transmits the data to the processor 301.

The processor 301 is responsible for managing the bus and general processing, and can also provide various functions, including timing, peripheral interfaces, voltage regulation, power management, and other control functions. The memory 302 can be used to store data used by the processor 301 when performing operations.

The fourth embodiment of the present disclosure relates to a computer-readable storage medium on which a computer program is stored. The above method embodiments are implemented when the computer program is executed by the processor.

That is, those skilled in the art can understand that all or part of the steps in the methods of the above embodiments can be completed by instructing relevant hardware through a program. The program is stored in a storage medium and includes several instructions to cause a device (may be a microcontroller, chip, etc.) or a processor to execute all or part of the steps of the methods of various embodiments of the present disclosure. The aforementioned storage media include: U disk, mobile hard disk, read-only memory (ROM), random access memory (RAM), magnetic disk or optical disk and other media that can store program code.

Those skilled in the art can understand that the above-mentioned embodiments are examples for implementing the present disclosure, and in actual applications, various changes can be made in form and details without departing from the scope of the present disclosure.

**Claims**

1. A method for controlling a battery pack, applied to a system for controlling the battery pack, the method **characterized by** comprising:

   dividing the battery pack into multiple battery subsystems;
   obtaining a step response matrix between each of the battery subsystems;
   establishing a battery pack objective function of the system for controlling the battery pack according to the step response matrix;
   obtaining a battery pack control function according to the battery pack objective function; and
   controlling a voltage and/or current output of each of the battery subsystems according to the battery pack control function.

2. The method for controlling the battery pack according to claim 1, wherein obtaining the step response matrix between each of the battery subsystems comprises:

   obtaining a transfer function of each of the battery subsystems; and
   obtaining the step response matrix according to the transfer function.

3. The method for controlling the battery pack according to claim 2, wherein obtaining the transfer function of each of the battery subsystems comprises:
   configuring each of the battery subsystems as a target battery subsystem in turn, and configuring a transfer function between an input of other battery subsystems except the target battery subsystem and an output of the target battery subsystem as a transfer function of the target battery subsystem.

4. The method for controlling the battery pack according to claim 3, wherein obtaining the step response matrix according to the transfer function comprises:

constructing a discrete difference model according to the transfer function of each of the battery subsystems, and using a recursive least squares algorithm to obtain a model parameter of the discrete difference model;
converting the discrete difference model into a non-parametric impulse response model;
obtaining an impulse response coefficient according to the non-parametric impulse response model; and
obtaining the step response matrix according to the impulse response coefficient.

5. The method for controlling the battery pack according to claim 1, wherein dividing the system for controlling the battery pack into the multiple battery subsystems comprises:

obtaining charge and discharge characteristics of each battery in the battery pack;
obtaining a battery model of each battery according to the charge and discharge characteristics; and
determining a battery subsystem corresponding to each battery according to the battery model.

6. The method for controlling the battery pack according to claim 1, wherein establishing the battery pack objective function of the system for controlling the battery pack according to the step response matrix comprises:

establishing a battery objective function for each of the batteries according to the step response matrix; and
establishing the battery pack objective function according to the battery objective function.

7. The method for controlling the battery pack according to claim 6, wherein controlling the battery pack according to the battery pack control function comprises:

calculating a Nash optimal solution of the battery pack objective function as the battery pack control function;
calculating a control current of each of the batteries according to the battery pack control function; and
controlling a voltage and/or current output of each of the batteries according to the control current of each of the batteries.

8. The method for controlling the battery pack according to claim 1, further comprising:

obtaining an overcurrent protection range of the battery pack;
setting a constraint matrix according to the overcurrent protection range and an overvoltage protection range; and
calculating a current output increment according to the constraint matrix,
wherein after obtaining the battery pack control function, the method further comprises:
controlling a voltage and/or current output of each of the batteries according to the battery pack control function and the current output increment.

9. A system for controlling a battery pack, **characterized by** comprising:

at least one processor; and
a memory communicated with the at least one processor;
wherein an instruction executable by the at least one processor is stored in the memory, and the instruction is executed by the at least one processor to enable the at least one processor to perform the method for controlling the battery pack according to any one of claims 1 to 8.

10. A computer-readable storage medium, **characterized in that** a computer program is stored on the computer-readable storage medium, and when the computer program is executed by a processor, the method for controlling the battery pack according to any one of claims 1 to 8 is implemented.

start

S101

dividing the battery pack into multiple battery subsystems

S102

obtaining a step response matrix between each battery subsystem

S103

establishing the battery pack objective function of the battery pack control system according to the step response matrix

S104

obtaining the battery pack control function according to the battery pack objective function

S105

controlling the battery pack according to the battery pack control function

end

FIG. 1

start

S201

distributing the battery pack control system into multiple battery subsystems

S202

obtaining the step response matrix between each battery subsystem

S203

establishing the battery pack objective function of the battery pack control system according to the step response matrix.

S204

minimizing the objective function and obtaining the battery pack control function.

S205

obtaining the overcurrent protection range of the battery pack, and obtaining the current output increment according to the overcurrent protection range

S206

controlling the battery pack according to the battery pack control function and the current output increment

end

FIG. 2

```
          ┌─────────────────────────┐──── S301
          │                         │
          │       controller        │
          │                         │
          └───────────┬─────────────┘
                      │
        ──────────┬───┴──────────
                  │
          ┌───────┴─────────────────┐──── 302
          │                         │
          │        memory           │
          │                         │
          └─────────────────────────┘
```

FIG. 3

## INTERNATIONAL SEARCH REPORT

| International application No. |
| --- |
| **PCT/CN2022/124837** |

| **A.** | **CLASSIFICATION OF SUBJECT MATTER** |
| --- | --- |

B60L 58/10(2019.01)i

According to International Patent Classification (IPC) or to both national classification and IPC

| **B.** | **FIELDS SEARCHED** |
| --- | --- |

Minimum documentation searched (classification system followed by classification symbols)

B60L

Documentation searched other than minimum documentation to the extent that such documents are included in the fields searched

Electronic data base consulted during the international search (name of data base and, where practicable, search terms used)

CNABS; CNTXT; VEN: 电池组, 子系统, 跃迁, 函数, 电流, 电压, 控制, battery, battery pack, sub, system, control, voltage, current, transition, function

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| A | CN 110783987 A (NANJING UNIVERSITY OF AERONAUTICS AND ASTRONAUTICS) 11 February 2020 (2020-02-11) description, paragraphs [0092]-[0201] | 1-10 |
| A | CN 107732331 A (ZHEJIANG UNIVERSITY) 23 February 2018 (2018-02-23) entire document | 1-10 |
| A | WO 2021001046 A1 (VOLVO TRUCK CORPORATION) 07 January 2021 (2021-01-07) entire document | 1-10 |
| A | US 2016018471 A1 (FORD GLOBAL TECHNOLOGIES, L.L.C.) 21 January 2016 (2016-01-21) entire document | 1-10 |

☐ Further documents are listed in the continuation of Box C.  ☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **16 December 2022** | **27 December 2022** |

| Name and mailing address of the ISA/CN | Authorized officer |
| --- | --- |
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/124837**

| Patent document cited in search report | | | Publication date (day/month/year) | Patent family member(s) | | | Publication date (day/month/year) |
|---|---|---|---|---|---|---|---|
| CN | 110783987 | A | 11 February 2020 | None | | | |
| CN | 107732331 | A | 23 February 2018 | None | | | |
| WO | 2021001046 | A1 | 07 January 2021 | EP | 3994023 | A1 | 11 May 2022 |
| | | | | US | 2022314835 | A1 | 06 October 2022 |
| | | | | CN | 114080330 | A | 22 February 2022 |
| US | 2016018471 | A1 | 21 January 2016 | DE | 102015110921 | A1 | 21 January 2016 |
| | | | | CN | 105277892 | A | 27 January 2016 |

Form PCT/ISA/210 (patent family annex) (January 2015)

**REFERENCES CITED IN THE DESCRIPTION**

**Patent documents cited in the description**

- CN 202111657500